# EUROPEAN PATENT APPLICATION

(11) **EP 2 717 331 A1**
(43) Date of publication of application: **09.04.2014**
(21) Application number: 12873082.7
(22) Date of filing: 29.03.2012
(51) Int. Cl.: H01L 31/042

(54) **COLLECTOR SHEET FOR SOLAR CELL, AND SOLAR CELL MODULE USING COLLECTOR SHEET FOR SOLAR CELL**

(71) Applicant: Dai Nippon Printing Co., Ltd., Tokyo 162-8001 (JP)
(72) Inventor: KOMAI, Takayuki, Tokyo 162-8001 (JP); EMOTO, Satoshi, Tokyo 162-8001 (JP)
(74) Representative: KATZAROV S.A.
(86) International application number: PCT/JP2012/058413
(87) International publication number: WO 2013/145220

(57) **Abstract**

Provided is a collector sheet for a solar cell, said collector sheet to be used in internal wiring of a solar cell module, and contributing to improvement of power generation efficiency. A collector sheet (5) for a solar cell is disposed, as internal wiring of a solar cell module (1), on the rear surface side of a solar cell element (4), and is provided with: a circuit (54), which is formed on the front surface of a resin base material (53), and which is configured of a wiring section (541) composed of a metal, and a non-wiring section (542); and an insulating layer (52), which is formed on the circuit (54). Light extraction to the solar cell element (4) due to reflection from the insulating layer (52) is increased, said insulating layer being disposed at the element periphery of the solar cell element (4), by having a white pigment contained in the insulating layer (52), and power generation efficiency is improved even in a back contact solar cell element.

## Description

### TECHNICAL FIELD

The present invention relates to a collector sheet for a solar cell for extracting electricity from a back contact solar cell element, and a solar cell module employing the same.

### BACKGROUND ART

In recent years, solar cells have been receiving attention as a clean energy source due to the rise in awareness of environmental problems. In general, a solar cell module constituting a solar cell has a configuration in which a transparent front substrate, a sealing material, a solar cell element, a sealing material and a rear surface protective sheet are laminated sequentially from the photoreception surface side, and has the function of generating electricity by sunlight being incident on the solar cell element.

In the solar cell module, normally, the rear surface protective sheet is a white rear surface protective sheet formed using a material containing a white pigment. In this manner, out of light incident from the transparent front substrate, light not absorbed into the solar cell element but transmitted through it is reflected, and the light is again absorbed into the solar cell element, thereby to allow improvement in power generation efficiency of the solar cell module (Patent Document 1).

Incidentally, the solar cell element has the photoreception surface to receive sunlight and a non-photoreception surface located on the rear side thereof, and there is known a back contact solar cell element in which an electrode is not disposed on the photoreception surface but a plurality of electrodes with different polarities are disposed on the non-photoreception surface, so as to enhance the photoreception efficiency of sunlight on the photoreception surface.

There are a variety of types of back contact solar cell elements. Other than a solar cell element of a metal wrap through (MWT) type, or an emitter wrap through (EWT) type, which includes a semiconductor substrate having a plurality of through holes that penetrate between the photoreception surface and the non-photoreception surface and in which a plurality of electrodes with different polarities are provided on the non-photoreception surface, there exists a solar cell element with a structure having no through hole, such as an interdigitated back-contact (IBC) type with a structure in which p-type and n-type diffusion layers in the shape of a comb are formed on the rear surface of the solar cell element and electricity is extracted from the p and n regions.

In a solar cell module provided with the back contact solar cell element, in order to extract electricity from the back contact solar cell element, a collector sheet for a solar cell is commonly used in which metal foil to become a circuit is laminated on the surface of a resin sheet as a substrate. With this collector sheet for a solar cell disposed between the solar cell element and the rear surface protective sheet, in the solar cell module provided with the back contact solar cell element, a large part of light incident from the transparent front substrate is blocked off by the collector sheet for a solar cell which is laminated with the metal foil, and does not reach the rear surface protective sheet.

Hence in the solar cell module provided with the back contact solar cell element, it is impossible, due to its structure, to reflect incident light on the rear surface protective sheet so as to improve the power generation efficiency of the solar cell module. However, there is an increasing demand for improvement in power generation efficiency of the solar cell module, and the solar cell module provided with the back contact solar cell element also requires an improvement in power generation efficiency.

[Patent Document 1] Japanese Unexamined Patent Application, Publication No.2007-177136

### DISCLOSURE OF THE INVENTION

### Problems to be Solved by the Invention

The present invention has been accomplished in order to solve the above problem, and an object of the present invention is to provide a collector sheet for a solar cell which is capable of improving power generation efficiency in a solar cell module provided with a back contact solar cell element, and a solar cell module using such a collector sheet for a solar cell.

### Means for Solving the Problems

The present inventors conducted extensive studies in order to solve the above problem. As a result, we found that the above problem can be solved by making some or all layers of the insulating layers being a white layer containing a white pigment, formed on a circuit made of a metal or the like on a collector sheet for a solar cell for use in a back contact solar cell element, and then completed the present invention. More specifically, the present invention provides the following.
(1) The present invention is a collector sheet for a solar cell which is disposed, as internal wiring of a solar cell module, on the rear surface side of a solar cell element, the sheet including: a circuit which is formed on the surface of a resin base material, and configured of a wiring section made of a metal and a non-wiring section; and an insulating layer which is formed on the circuit, wherein the insulating layer is provided with a white layer containing a white pigment.
(2) Furthermore, the present invention is the collector sheet for a solar cell according to (1), wherein the white pigment has a particle diameter of 0.5 µm or more and 1.5 µm or less.
(3) Furthermore, the present invention is the collector sheet for a solar cell according to either (1) or (2), wherein the reflectance of light with a wavelength of 450 nm to 800 nm on the insulating layer is no less than 65%, and the reflectance of light with a wavelength of 800 nm to 1100 nm on the insulating layer is no less than 75%.
(4) Furthermore, the present invention is the collector sheet for a solar cell according to any one of (1) to (3), wherein the thickness of the insulating layer is from no smaller than 18 µm and to no larger than 25 µm.
(5) Furthermore, the present invention is a solar cell module, including the collector sheet for a solar cell according to any one of (1) to (4), and a back contact solar cell element.

### Effects of the Invention

According to the present invention, since sunlight is reflected on an insulating layer of a collector sheet for a solar cell which is laminated directly under a solar cell element in a solar cell module, sunlight can be efficiently reflected even in a solar cell module provided with a back contact solar cell element, thus allowing improvement in power generation efficiency of the solar cell module.

### BRIEF DESCRIPTION OF THE DRAWINGS

FIG. 1 is a sectional schematic view illustrating one example of the layer structure of a solar cell module provided with a back contact solar cell element;
FIG. 2 is a partial enlarged view of a cross section of the solar cell module provided with the back contact solar cell element schematically showing the travelling and reflection route of sunlight in the solar cell module, the light being incident on the module;
FIG. 3 is a sectional schematic view illustrating one example of the layer structure of the solar cell module provided with the back contact solar cell element; and
FIG. 4 is a diagram showing the reflectance (%) of light with a wavelength of 250 nm to 1200 nm in each of Examples 1 and 2 and Comparative Examples 1 to 4.

### EXPLANATION OF REFERENCE NUMERALS

1. Solar cell module
2. Transparent front substrate
3. Front surface sealing material layer
4. Solar cell element
5. Collector sheet for a solar cell
51. Rear surface sealing material layer
52. Insulating layer
53. Resin base material
54. Circuit
6. Rear surface protective sheet
7. Conductive recessed section

### PREFERRED MODE FOR CARRYING OUT THE INVENTION

Hereinafter, one embodiment of the collector sheet for a solar cell according to the present invention, and the solar cell module using the collector sheet for a solar cell will be described in detail. The present invention is not limited to the embodiment described below.

### Collector sheet for solar cell

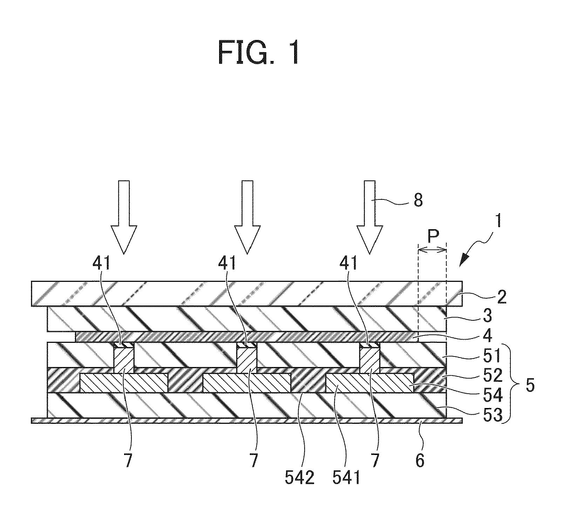

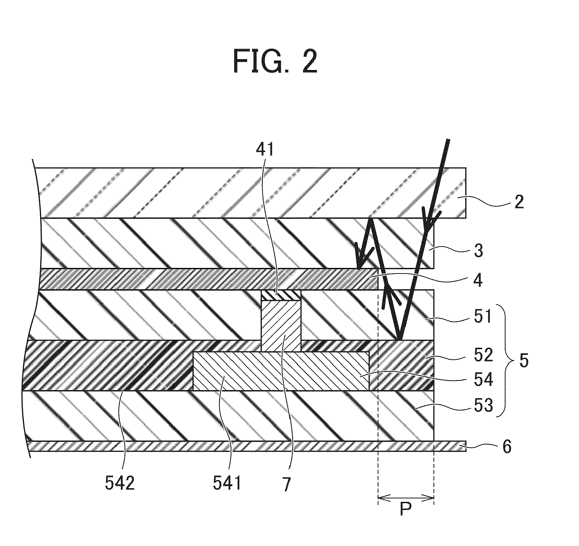

A collector sheet for the solar cell according to the present invention will be described below with reference to FIGS. 1 and 2. As shown in FIG. 1, the collector sheet 5 for a solar cell is provided with a rear surface sealing material layer 51, an insulating layer 52, a resin base material 53, and a circuit 54. Although the rear surface sealing material layer 51 is not an essential constitutional element of the present invention, the collector sheet for a solar cell which is provided with the rear surface sealing material layer 51 will be described below as one embodiment.

In the collector sheet 5 for a solar cell, a circuit 54 composed of a wiring section 541 made of a metal such as copper and a non-wiring section 542 is formed on the surface of the resin base material 53. The insulating layer 52 is then formed covering the circuit 54. The rear surface sealing material layer 51 is formed on the upper surface of the insulating layer 52. Furthermore, a conductive recessed section 7 penetrating from the upper surface of the rear surface sealing material layer 51 to the upper surface of the circuit 54 through the insulating layer 52 is formed.

### Insulating layer

Subsequently, an insulating layer to be formed on the collector sheet for a solar cell according to the present invention will be described. It has hitherto been common, in the collector sheet for a solar cell for use in the back contact solar cell element, to form an insulating layer on a circuit so as to prevent a short circuit between electrodes. Furthermore, the insulating layer is often formed by a variety of curing insulating inks, and commonly has a color being transparent or translucent. The collector sheet for a solar cell according to the present invention is characterized by providing the insulating layer with the function of reflecting sunlight to improve power generation efficiency, on top of the conventional effect of preventing a short circuit by coloring the insulating layer so as to be a white layer.

As shown in FIG. 2, in the solar cell module 1 according to the present invention, the insulating layer 52 is disposed also in an element surrounding region P as a region not disposed with the solar cell element in a planar view of the solar cell module 1. For this reason, sunlight not absorbed into the solar cell element 4 is reflected on the surface of the insulating layer 52 in the element surrounding region P of the collector sheet 5 for a solar cell, and the reflected sunlight is further reflected on a transparent front substrate 2, to be absorbed into the solar cell element 4.

A conventionally known insulating material such as thermosetting insulating ink like epoxy-phenol based ink, or an ultraviolet curable insulating coat agent like an acrylic one can be used as the insulating agent for forming the insulating layer 52.

A white pigment is added to the above insulating agent before formation of the insulating layer so as to color the insulating layer 52 as a white layer. The type of the white pigment is not particularly limited, and a conventional white pigment such as titanium oxide and zinc oxide can be used. Since the white layer usually efficiently reflects sunlight in the visible light region, making the insulating layer a white layer, this can contribute to improvement in electric power generation efficiency of the solar cell module.

In the present invention, the white pigment to be added to the insulating material preferably has a particle diameter of 0.5 µm or more and 1.5 µm or less. When the particle diameter of the white pigment is in the above range, the white layer efficiently reflects even near-infrared light in addition to the visible light region, thereby allowing further contribution to improvement in electric power generation efficiency of the solar cell module.

A value is adopted as the particle diameter which is obtained by photographing the primary particle diameter of a white pigment by using transmission electron microscopy (JEM-1230) produced by JEOL Ltd., and then performing statistical processing on the image by using image analysis particle distribution measurement software (MAC-View Ver. 3) produced by Mountech Co. Ltd. In the calculation of the particle diameter, an equivalent circle diameter on a mass basis is adopted.

In the present invention, in the white pigment to be added to the insulating material, white pigment particles each having a particle diameter of 0.8 µm or more and 1.2 µm or less are preferably 80 percent by mass or more of all of the white pigment particles. As it enhances the near-infrared ray reflection effect of the white layer.

In addition, in order to efficiently reflect light in the visible region with a wavelength of 750 nm or less, a white pigment, in which white pigment particles, each having a particle diameter of 0.2 µm or more and 0.6 µm or less, are no less than 60 percent by mass of all of the white pigment particles, preferably accounts for no less than 10 percent by mass and no more than 20 percent by mass of the entire white pigment.

A representative example of the white pigment with a particle diameter of 0.5 µm or more and 1.5 µm or less is titanium oxide, and also in the present invention, it is preferable to use titanium oxide as the white pigment. Here, titanium oxide includes surface-treated titanium oxide. For example, in the case of titanium oxide, it can be produced in such a manner as follows.

It can be produced so that hydrous titanium oxide is used as a raw material, and titanium oxide therein is combined with 0.1 percent by mass or more and 0.5 percent by mass or less of an aluminum compound in terms of aluminum, 0.1 percent by mass or more and 0.5 percent by mass or less of an potassium compound in terms of potassium carbonate and 0.2 percent by mass or more and 1.0 percent by mass or less of an potassium compound in terms of zinc oxide, which is then dried and roasted. Hereinafter, each material for use in the above production will be briefly described and a more specific production method will be described.

Hydrous titanium oxide that is used as the raw material can be formed by treating titanium-containing ore such as ilmenite or rutile and removing impurities, followed by addition of water thereto or the oxidation thereof. Furthermore, it can also be formed by hydrolyzing titanalkoxide. In the present invention, metatitanic acid is preferable which is extracted as an intermediate product in a sulfuric acid method known as an industrial production method for titanium oxide.

There are no limits on the sort of the aluminum compound to be added to hydrous titanium oxide so long as it is a compound not having an adverse effect on characteristics of ultimately obtained titanium oxide as an object of the present invention, but other than oxides and hydrous oxides, it is preferably a water-soluble compound. Specifically, aluminum sulfide, aluminum chloride and the like are preferable. The amount of the aluminum compound added is preferably 0.1 percent by mass or more and 0.5 percent by mass or less in terms of oxide aluminum with respect to titanium oxide.

There are also no limits on the sort of the potassium compound to be added to hydrous titanium oxide as in the case of the aluminum compound, but specifically, potassium hydroxide, potassium chloride and the like are preferable. The amount of the potassium compound added is preferably no smaller than 0.2 percent by mass and no larger than 0.5 percent by mass in terms of potassium carbonate with respect to titanium oxide. In the absence of the potassium compound or in the presence of a trace amount thereof, the particles are melted with one another vigorously making it difficult to be dispersed by the primary particle diameter, thus becoming unlikely to reflect near-infrared rays. On the contrary, when the amount added is excessive, titanium oxide particles obtained by roasting are rod-shaped, to causing deterioration in the near-infrared light reflection effect. Furthermore, a rutilated ratio at an optimal particle diameter is lowered.

There are also no limits on the sort of the zinc compound to be added to hydrous titanium oxide as in the case of the above other metal components, but specifically, zinc oxide, zinc sulfate, zinc chloride and the like are preferable. The amount of the zinc compound added is preferably no less than 0.2 percent by mass and no more than 1.0 percent by mass in terms of zinc oxide with respect to titanium oxide. In the absence of the zinc compound and in the presence of a trace amount thereof, titanium oxide particles after roasting are rod-shaped causing deterioration in the near-infrared light reflection effect. Furthermore, a high roasting temperature is required for growing the particles, resulting in that the particles are melted with one another vigorously, making it difficult to be dispersed by the primary particle diameter, thus causing deterioration in near-infrared light reflection effect. It is to be noted that the zinc compound readily reacts with titanium oxide, to generate zinc titanate. Zinc titanate has a low refraction index as compared to titanium oxide. For this reason, with the increase in the amount of zinc, the infrared reflection effect deteriorates, and hence an excessive added amount is not preferable.

Specifically, for example, titanium oxide with a particle diameter of 0.5 µm or more and 1.5 µm or less can be produced in such a manner as follows.

As a method for adding the above metal component to hydrous titanium oxide, there are methods such as physical mixing by drying and wet-mixing into a slurry, but wet-dispersion is more preferably performed so as to allow dispersion of the added metal component into each of the titanium oxide particles. In particular, a hydrous titanium oxide material after removal of impurities, obtained as an intermediate product in industrial production, may be dispersed in a medium such as water according to the requirement, which may be combined with a compound containing the above-added component and then sufficiently stirred.

The foregoing metal components of aluminum, potassium and zinc are mixed into hydrous titanium oxide and then dried with a dryer. At this time, the drying is performed so that titanium oxide (TiO₂) accounts for 50% or more and 65% or less of the total mass.

In roasting of hydrous titanium oxide after the above drying thereof, the treatment is performed at 900°C or higher and 1100°C or lower as the temperature range to be capable of normally roasting titanium oxide for a pigment. When the temperature shifts from this temperature region to the lower temperature side, the primary particle diameter does not sufficiently grow, causing deterioration in the desired near-infrared light reflection effect. On the contrary, when it shifts to the high temperature side, excessive sintering occurs among the particles and crushing properties thereof deteriorate, resulting in deterioration in the near-infrared light reflection effect.

The thickness of the white insulating layer 52 (the thickness of the insulating layer refers to the thickness from the upper surface of the wiring section 541 to the lower surface of the rear surface sealing material layer 51) is preferably from 12 µm or more to 25 µm or less, and more preferably from 18 µm or more to 25 µm or less. When the thickness is smaller than 12 µm, this is not preferable due to insufficiency of the insulating properties, and when it is smaller than 18 µm, reflectance in the visible light region decreases as compared with the case of it being 18 µm or more, whereby it is more preferably 18 µm or more. Moreover, even when the thickness exceeds 25 µm, no further insulating and reflection effects can be obtained, but pattern formation of the conductive recessed section 7 becomes rather difficult while it is uneconomical, which is thus not preferable.

It is to be noted that in the present invention, the white pigment may be contained in the whole insulating layer 52, or may be contained only in a certain layer or layers. Containing it only in a certain layer or layers, such as an intermediate layer, can efficiently prevent deterioration in adhesive properties and the like.

### Other constitutional elements of collector sheet for solar cell

The rear surface sealing material layer 51 is provided for fixing the position of the solar cell element 4 in the solar cell module 1 and for alleviating impacts on the solar cell element from the outside. The rear surface sealing material layer 51 is formed on the insulating layer 52 except for the place occupied by the conductive recessed section 7. It is to be noted that the rear surface sealing material layer 51 is not necessarily essential in the present invention.

A conventionally known sealing material for use in a solar cell module is applicable as the sealing material to form the rear surface sealing material layer 51, and, for example, an ethylene-vinyl acetate copolymer resin (EVA), ionomer, polyvinyl butyl (PVB) or an olefin-based sealing material such as polyethylene may be used.

The thickness of the rear surface sealing material layer 51 is preferably 100 µm or more and 600 µm or less. When the thickness is smaller than 100 µm, impacts cannot be sufficiently alleviated; however, when the thickness exceeds 600 µm, no further effect can be obtained, but pattern formation of the conductive recessed section 7 becomes rather difficult while it is uneconomical, which is thus not preferable. It is to be noted that in the collector sheet for the solar cell according to the present invention, since the rear surface sealing material layer 51 needs to transmit light that enters into the insulating layer 52 and light that is reflected on the insulating layer 52 as much as possible, a colorless and transparent layer with a high light transmittance, or a layer with a color close thereto is preferable.

The resin base material 53 is a resin molded into the shape of a sheet. Examples of the resin constituting the resin base material 53 include a polyethylene resin, a polypropylene resin, an annular polyolefin-based resin, a polystyrene-based resin, an acrylonitrile-styrene copolymer, an acrylonitrile-butadiene-styrene copolymer, a polyvinyl chloride-based resin, a fluorine-based resin, a poly(meth)acrylic resin, a polycarbonate-based resin, polyester-based resins such as polyethyleneterephthalate (PET) and polyethylenenaphthalate (PEN), a polyamide-based resin such as a variety of nylon, a polyimide-based resin, a polyamideimide-based resin, a polyallyl phthalate-based resin, a silicon-based resin, a polysulfone-based resin, a polyphenylene sulfide-based resin, a polyether sulfone-based resin, a polyurethane-based resin, an acetal-based resin and a cellulose-based one.

The thickness of the resin base material 53 may be set as appropriate in accordance with the strength, thinness and the like which are required for the collector sheet 5 for a solar cell. The thickness of the resin base material 53 is not particularly limited, but as one example thereof, 20 to 250 µm can be cited.

The circuit 54 is electric wiring formed on the surface of the collector sheet 5 for a solar cell so as to have the desired wiring shape. The wiring section 541 of the circuit 54 is a layer made of a metal such as copper. Examples of a method for forming the circuit 54 on the surface of the resin base material 53 include a method in which copper foil is joined to the surface of the resin base material 53 and the copper foil is then patterned by etching processing or the like.

The thickness of the circuit 54 may be set as appropriate in accordance with the magnitude of the withstand current or the like which is required for the collector sheet 5 for a solar cell. The thickness of the circuit 54 is not particularly limited, but as one example thereof, 10 to 50 µm can be cited.

As shown in FIG. 1, the conductive recessed section 7 is formed so as to be located directly under the electrode 41 of the solar cell element 4 in the solar cell module 1. The conductive recessed section 7 is a hole that penetrates from the upper surface section of the rear surface sealing material layer 51 to the upper surface of the wiring section 541 through the insulating layer 52.

### Production method for collector sheet for solar cell

In a production method for the collector sheet 5 for the solar cell according to the present embodiment, first, a laminate sheet is used where a conductive layer made of a metal such as copper is laminated onto the surface of the resin base material 53. An etching step and a peeling step are performed on this laminate sheet to form the circuit 54 on the collector sheet 5 for a solar cell. Furthermore, an insulating coating step is performed on the laminate sheet formed with the circuit 54, to form the insulating layer 52 on the circuit 54, and a sealing material layer laminating step is then performed in the form of lamination on the insulating layer 52, to form the rear surface sealing material layer 51 on the insulating layer 52. Hereinafter, the etching step, the peeling step, the insulating coating and the sealing material layer laminating step will be described.

### [Etching step]

First, the etching step will be described. This step is a step in which an etching mask (not shown) patterned into the desired shape of the circuit 54 is produced on the surface of the above laminate sheet and thereafter the etching processing is performed, thereby to remove the conductive layer in the place not covered by the etching mask.

As described above, the laminate sheet for use in this step is one in which the conductive layer made of a metal such as copper is formed on the surface of the resin base material 53. Examples of a method for forming the conductive layer made of a metal such as copper on the surface of the resin base material 53 include a method of making copper foil adhere to the surface of the resin base material 53 with an adhesive and a method of vapor-depositing the copper foil onto the surface of the resin base material 53, but from the viewpoint of cost, the method of making copper foil adhere to the surface of the resin base material 53 with an adhesive is useful. Among them, there is a method of making the copper foil adhere to the surface of the resin base material 53 by a dry laminating method using an adhesive such as a urethane, polycarbonate or epoxy adhesive.

In this step, first, an etching mask (not shown) patterned into the desired shape of the wiring section 541 is produced on the shape of the surface of the above laminate sheet (namely, the surface of the above conductive layer). In the etching step, the etching mask is provided to avoid corrosion of the conductive layer, which will be the wiring section 541, due to an immersion liquid. The method for forming such an etching mask is not particularly limited, and for example, the etching mask may be formed on the surface of the laminate sheet by exposing a photoresist or a dry film through a photo mask and then developing it, or the etching mask may be formed on the surface of the laminate sheet by means of a printing technique such as an inkjet printer. In the peeling step, which will be described later, the etching mask needs to be peelable by means of an alkaline peeling liquid. From this viewpoint, it is preferable to produce the etching mask by using the photoresist or the dry film.

Next, the etching processing in the etching step will be described. This processing is processing for removing the conductive layer in the place not covered by the etching mask by means of the immersion liquid. Through this processing, the portion other than the place to become the wiring section 541 is removed from the conductive layer, and hence the conductive layer is left in the desired shape of the wiring section 541 on the surface of the resin base material 53.

### [Peeling step]

Next, the etching mask is removed using the alkaline peeling liquid in the peeling step. Through this step, the etching mask is removed from the surface of the wiring section 541. Examples of the alkaline peeling liquid for use in the peeling step include a caustic soda solution with a predetermined concentration.

### [Insulating coating step]

Next, a method will be described for forming the white insulating layer 52 on the circuit 54 of the collector sheet 5 for a solar cell. Insulating ink is taken as a main component, and this is combined with a white pigment, and further arbitrarily combined, if necessary, with one or more than one additive, which are an ultraviolet absorbent, a plasticizer, a light stabilizer, an antioxidant, an antistatic agent, a crosslinking agent, a curing agent, a sealant, a lubricant, a strengthening agent, a reinforcement agent, a fire retardant, a flame-resistant agent, a foaming agent, a fungicide, a coloring agent such as a pigment and a dye, and the like, and is moreover combined, if necessary, with a solvent, a dilution agent or the like, followed by sufficient kneading, to prepare an ink composition. A conventionally known ink such as a thermo-setting insulating ink or an ultraviolet curable insulating coat agent can be used as the above insulating ink as described above. The ink composition prepared above is used, and this is made to cover the portion except for the conductive recessed section 7 in the wiring section 541 and the non-wiring section 222 of the circuit 54, followed by application and printing, to allow formation of a white insulating layer.

In the case of forming the white insulating layer, for example, it is preferably formed by the following method. First, an ink composition with a solid ratio of no less than 20% and no more than 50% is prepared. Herein, 10 percent by mass or more and 100 percent by mass or less of the white pigment is blended with respect to the whole solid. Subsequently, this ink composition is applied to the portion except for the conductive recessed section 7 in the wiring section 541 and the non-wiring section 222 of the circuit 54. The applied amount is set to be 5 g/m² or more and 40 g/m² or less. When the thermosetting insulating ink is used as the insulating ink, the ink composition is cured by the heat of heating and pressing at the time of producing the solar cell module, to form the white insulating layer. When the ultraviolet curable insulating coat agent is used as the insulating ink, the ink composition is cured by irradiation with ultraviolet light to form the white insulating layer.

### [Sealing material laminating step]

Although the method for forming the rear surface sealing material layer 51 is not particularly limited, for example, after the sealing material has been formed into the shape of a sheet, a through hole is previously formed by punching or the like in a position to form the conductive recessed section 7, and the sealing material is laminated so that a recessed section formed by the insulating layer 52 and the through hole are superimposed onto each other to allow formation of the penetrating conductive recessed section 7 on the circuit 54.

### Other embodiments of collector sheet for solar cell

As described later, the collector sheet 5 for a solar cell becomes the solar cell module 1 after going through the step of integration with other members besides the solar cell element 4, but prior to that step, the rear surface protective sheet 6 of ETFE as a fluorine-based resin film or hydrolysis-resistant PET, which is different from the above members, is previously integrated with the rear surface side of the resin base material 53, thereby allowing formation of the rear surface protective sheet-integrated sheet which is used for production of the solar cell module 1. For creating the rear surface protective sheet-integrated sheet, the rear surface protective sheet 6 is laminated onto the rear surface side of the resin base material 53 by a dry lamination method or the like.

### Solar cell module

Next, a solar cell module will be described which is to be provided with a back contact solar cell element where the collector sheet for a solar cell according to the present invention is used. FIG. 1 is a sectional schematic view illustrating one example of the layer configuration of the solar cell module 1 provided with the back contact solar cell element. The solar cell module 1 is configured by sequentially laminating, from the photoreception surface side of incident light 8, the transparent front substrate 2 made of glass or the like, a front surface sealing material layer 3 made of an ethylene-vinyl acetate copolymer resin (EVA), ionomer, polyvinyl butyl (PVB) or polyethylene, the solar cell element 4, the collector sheet 5 for a solar cell which is configured from the rear surface sealing material layer 51, the insulating layer 52, the resin base material 53 and the like, and the rear surface protective sheet 6 made of ETFE as a fluorine-based resin film, hydrolysis-resistant PET or the like. Electricity extracted from the electrode 41 is conducted to the corresponding wiring section 541 via a conductive material in the conductive recessed section 7.

### Production method for solar cell module

For producing the solar cell module 1, the conductivity recessed section 7 of the collector sheet 5 for a solar cell is filled with a conductive material prior to the step of integrating the collector sheet 5 for a solar cell, the solar cell element 4 and the other members. Examples of this conductive material include a conductive material such as solder. Hence, the conductive recessed section 7 is formed so that the wiring section 541 is exposed on the bottom surface thereof, whereby conductivity is provided between the conductive material and the wiring section 541.

Next, the transparent front substrate 2, the front surface sealing material layer 3, the solar cell element 4, the collector sheet 5 for a solar cell which is configured from the rear surface sealing material layer 51, the insulating layer 52 and the resin base material 53, and the rear surface protective sheet 6 are laminated and integrated. Examples of a method for this integration include a method for integration by vacuum heat laminating. The laminating temperature at the time of using the above method is preferably within the range of 130°C to 190°C. Furthermore, the laminating time is preferably within the range of 5 to 60 minutes, and particularly preferably within the range of 8 to 40 minutes. It is to be noted that in the solar cell module according to the present invention, the transparent front substrate 2, the front surface sealing material layer 3 and the rear surface sealing material layer 51 need to transmit light that enters into the insulating layer 52 and light that is reflected on the insulating layer 52 as much as possible, and hence each of these layers is preferably a colorless and transparent layer with high light transmittance, or a layer with a color close thereto.

In the process of this integration, the resin base material 53 of the collector sheet 5 for a solar cell is firmly integrated with other members as the solar cell module. Then, in the planar view of the solar cell module 1, the insulating layer 52 of the present invention is disposed in the element surrounding region P as the region not disposed with the solar cell element.

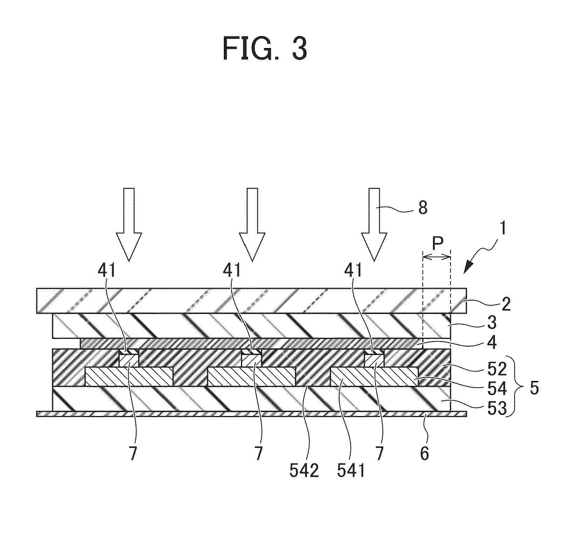

In addition, although the collector sheet for a solar cell which is provided with the rear surface sealing material layer 51 has been described in this embodiment, in the collector sheet for a solar cell according to the present invention, with the rear surface sealing material layer 51 being not an essential constitutional element, for example as shown in FIG. 3, the collector sheet 5 for a solar cell may be configured so that the solar cell element 4 is disposed directly onto the insulating layer 52 without provision of the rear surface sealing material layer. Such a collector sheet for a solar cell is naturally within the range of the present invention.

### EXAMPLES

Hereinafter, the present invention will be more specifically described by means of Examples, but the present invention is not restricted to the Examples below.

### Example 1

In the method shown below, a sample of the collector sheet for a solar cell having a white insulating layer with a film thickness of 20 µm was produced.

First, titanium oxide with a particle diameter of 1 µm and commercially available acrylic ultraviolet curable insulating coat agent were blended so as to be distributed in proportion of 20 percent by mass and 80 percent by mass, respectively, to prepare a white insulating ink composition.

Subsequently, a joined body was formed obtained by making copper foil with a thickness of 35 µm adhere to the surface of the PET film with a thickness of 100 µm by the dry laminating method.

The above white insulating ink composition was applied onto the copper foil surface of the joined body by screen printing so as to make the applied film have a thickness of 20 µm, thereby forming a sample of the collector sheet for a solar cell of Example 1.

### Example 2

In a method shown below, a sample of the collector sheet for a solar cell having a white insulating layer with a film thickness of 13 µm was produced.

First, a white pigment with the same composition as in Example 1 was prepared, and subsequently, a white insulating ink composition with the same composition as in Example 1 was prepared, to form the same joined body as in Example 1.

The above white insulating ink composition was applied onto the copper foil surface of the joined body by screen printing so as to make the applied film have a thickness of 13 µm, to form a sample of the collector sheet for a solar cell of Example 2.

### Comparative Example 1

When the insulating layer is transparent as in the conventionally known collector sheets for a solar cell, it is thought that sunlight is transmitted through the insulating layer and mainly reflected on the copper foil surface on the circuit. For comparison with those cases, a joined body, obtained by making copper foil with a thickness of 35 µm adhere to the surface of the PET film with a thickness of 100 µm by the dry laminating method, was produced as a sample of the collector sheet for a solar cell having a transparent insulating layer.

### Comparative Example 2

In order to verify the contribution of the copper foil surface to the improvement in reflectance in the insulating layer of the collector sheet for a solar cell according to the present invention, the above white insulating ink composition was applied to the surface of the ETFE film with a thickness of 50 µm by screen printing so as to make the applied film have a thickness of 20 µm, thereby producing a sample (without the copper foil surface) of the collector sheet for a solar cell having a white insulating layer with a film thickness of 20 µm.

### Comparative Example 3

In the method shown below, a sample of the collector sheet for a solar cell having a black insulating layer was produced.

First, carbon black and commercially available acrylic ultraviolet curable insulating coat agent were blended so as to be distributed in proportion of 10 percent by mass and 90 percent by mass, respectively, to prepare a black insulating ink composition.

Subsequently, the same joined body as in Example 1 was formed, and the above black insulating ink composition was applied onto the copper foil surface of the joined body by screen printing so as to make the applied film have a thickness of 20 µm, thereby forming a sample of the collector sheet for a solar cell having the black insulating layer.

### Comparative Example 4

As one aspect of the conventionally known solar cell module, there is one in which the rear surface protective sheet is made white and sunlight is reflected thereon, to seek for an improvement in electric power generation efficiency. Herein, a titanium oxide-added white 50-µm PET film ("E20F", produced by Toray Industries, Inc.) was used as a sample of the white the rear surface protective sheet.

### Evaluated examples

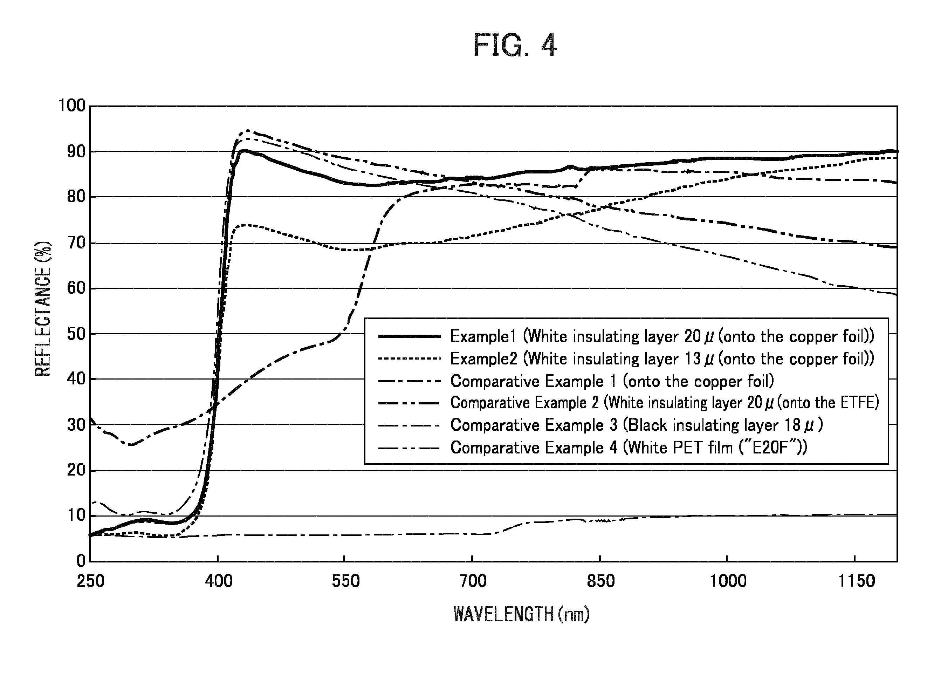

Using a spectrophotometer ("UV-31 00", produced by Shimadzu Corporation), the reflectance (%) of light with a wavelength from 250 nm to 1200 nm was evaluated at the time of light being incident in each of Examples 1, 2 and Comparative Examples 1 to 4. In Examples 1, 2 and Comparative Examples 2, 3, light was incident on the insulating layer side of the sample, and in Comparative Example 1, light was incident on the copper foil surface side of the sample. FIG. 4 shows evaluation results.

From the evaluation results of Examples 1 and 2 in FIG. 4, it was confirmed that the collector sheet for a solar cell which is provided with the white insulating layer according to the present invention has a reflectance no less than 65% in almost all ranges of the visible light region (wavelength range of 450 nm to 800 nm), and a reflectance no less than 75% in a predetermined region (wavelength range of 800 nm to 1100 nm) out of the near-infrared light region, and the reflectance is high in each of these ranges. In general, the solar cell element has high spectral sensitivity to light with a wavelength of 500 nm to 1100 nm although the width of the element slightly varies depending on the sort thereof, such as an amorphous type, a polycrystalline type and a monocrystalline type. It is found from this that the collector sheet for a solar cell which is provided with the white insulating layer according to the present invention can sufficiently contribute to the improvement in power generation efficiency.

It was confirmed from the comparison between Example 1 and Example 2 that in the collector sheet for a solar cell which is provided with the white insulating layer according to the present invention, when the insulating layer has a smaller thickness than a certain value, the reflectance slightly decreases mainly in the visible light region. This is considered to be because when the insulating layer is thin, the reflectance is strongly influenced by the relative lowness of the reflectance of the copper foil surface in the visible light region. It is found from this that the thickness of the insulating layer is preferably no smaller than 18 µm.

It was confirmed from the comparison with Comparative Example 1 that, as compared with the case of light being reflected on the copper foil surface on the circuit in the solar cell module laminated with the collector sheet for a solar cell which is provided with the conventional transparent insulating layer, the collector sheet for a solar cell which is provided with the white insulating layer according to the present invention has an obviously higher reflectance mainly in the visible light region, and also has an almost equivalent reflectance or a higher reflectance than that in the near-infrared light region.

In the near-infrared light region, the reflectance in Comparative Example 2 gradually decreases and is relatively lower than those in Examples 1 and 2. It was confirmed from this that especially in the near-infrared light region, the extent of the reflectance of the copper foil surface also contributes to the improvement in reflectance of the collector sheet for a solar cell which is provided with the white insulating layer according to the present invention.

It was confirmed from the comparison with Comparative Example 4 that in the solar cell module having a solar cell element being not the conventional back contact type, the collector sheet for a solar cell which is provided with the white insulating layer according to the present invention has almost an equivalently high reflectance as compared with the case of light being reflected on the rear protective sheet made of a white PET film.

These results mean that in the case of producing the solar cell module by use of the collector sheet for a solar cell according to the present invention, the power generation efficiency of the solar cell module improves due to reflection of sunlight on the white insulating layer formed on the circuit made of a metal.

## Claims

1. A collector sheet for a solar cell which is disposed, as internal wiring of a solar cell module, on the rear surface side of a back contact solar cell element, the sheet comprising:
a circuit which is formed on the surface of a resin base material, and configured of a wiring section made of a metal and a non-wiring section; and
an insulating layer which is formed on the circuit,
wherein the insulating layer is provided with a white layer containing a white pigment.

2. The collector sheet for the solar cell according to claim 1, wherein the white pigment has a particle diameter of 0.5 µm or more and 1.5 µm or less.

3. The collector sheet for the solar cell according to either claim 1 or 2, wherein
the reflectance of light with a wavelength of 450 nm to 800 nm on the insulating layer is 65% or more, and
the reflectance of light with a wavelength of 800 nm to 1100 nm on the insulating layer is 75% or more.

4. The collector sheet for the solar cell according to any one of claims 1 to 3, wherein the thickness of the insulating layer is from 18 µm or more to 25 µm or less.

5. A solar cell module, comprising:
the collector sheet for a solar cell according to any one of claims 1 to 4; and
a back contact solar cell element.
